Europäisches Patentamt

European Patent Office

Office européen des brevets

(11) Veröffentlichungsnummer: **0 283 856**
**A1**

## (12) EUROPÄISCHE PATENTANMELDUNG

(21) Anmeldenummer: **88103737.8**

(22) Anmeldetag: **09.03.88**

(51) Int. Cl.⁴: **H03K 17/08**

(30) Priorität: **20.03.87 DE 3709120**

(43) Veröffentlichungstag der Anmeldung:
**28.09.88 Patentblatt 88/39**

(84) Benannte Vertragsstaaten:
**AT BE CH DE ES FR GB GR IT LI LU NL SE**

(71) Anmelder: **Nixdorf Computer
Aktiengesellschaft
Fürstenallee 7
D-4790 Paderborn(DE)**

(72) Erfinder: **Pollmeier, Werner
Mozartweg 8
D-4837 Verl 1(DE)**

(74) Vertreter: **Patentanwälte Schaumburg &
Thoenes
Mauerkircherstrasse 31 Postfach 86 07 48
D-8000 München 80(DE)**

(54) **Schaltungsanordnung zum Reduzieren der Verlustleistung beim Sperren eines eine Induktivität an eine Spannungsquelle anschaltenden Halbleiterschalters.**

(57) Bei getakteten Stromversorgungsgeräten kann die Verlustleistung beim Sperren des die Primärwicklung (11) eines Stromwandlerübertragers (12) schaltenden Halbleiterschalters (10) durch einen Kondensator (16) reduziert werden, der in einem die Reihenschaltung einer Drosselspule (17) und einer Diode (28) enthaltenden Stromkreis liegt und mit Sperren des Halbleiterschalters (10) in einem weiteren, eine Diode (19) und die Primärwicklung (11) enthaltenden Stromkreis entladen wird. Schädliche Überspannungen, die an der Reihenschaltung von Drosselspule und erster Diode (18) auftreten und durch Inversströme während der Sperrverzögerungszeit der ersten Diode (18) hervorgerufen werden, werden durch eine dritte Diode (23) zur Sapnnungsquelle abgeleitet, so daß dadurch die während des Umschaltens der ersten Diode (18) in der Drosselspule (17) gespeicherte Energie zur Spannungsquelle zurückgeführt wird und somit nicht als Verlustleistung vernichtet werden muß. Die erste und die dritte Diode (18, 23) bilden eine Reihenschaltung, die in Sperrichtung an die Spannungsquelle angeschaltet ist.

Fig. 2

## Schaltungsanordnung zum Reduzieren der Verlustleistung beim Sperren eines eine Induktivität an eine Spannungsquelle anschaltenden Halbleiterschalters

Die Erfindung betrifft eine Schaltungsanordnung zum Reduzieren der Verlustleistung beim Sperren eines eine Induktivität an eine Spannungsquelle anschaltenden Halbleiterschalters, mit einem an die Verbindung von Halbleiterschalter und Induktivität angeschalteten Kondensator, der in einem den Halbleiterschalter, eine Drosselspule und eine erste Diode enthaltenden ersten Stromkreis und in einem eine zweite Diode und die Induktivität enthaltenden zweiten Stromkreis liegt, wobei die zweite Diode so gepolt ist, daß ein Entladestrom des Kondensators in Richtung des mit dem Halbleiterschalter geschalteten Stroms durch die Induktivität fließt, und mit einer an den Verbindungspunkt von erster Diode und Drosselspule angeschlossenen Spannungsbegrenzungsschaltung.

Eine Schaltungsanordnung dieser Art wird in dem Netzteilmodul 3109 der Nixdorf Computer AG verwendet. Dabei handelt es sich um ein getaktetes Stromversorgungsgerät, in dem der Halbleiterschalter die Primärwicklung eines Übertragers impulsgesteuert an eine Gleichstromquelle anschaltet, so daß auf der Sekundärseite des Übertragers mit der dort nach Gleichrichtung erhaltenen Gleichspannung eine Last gespeist werden· kann.

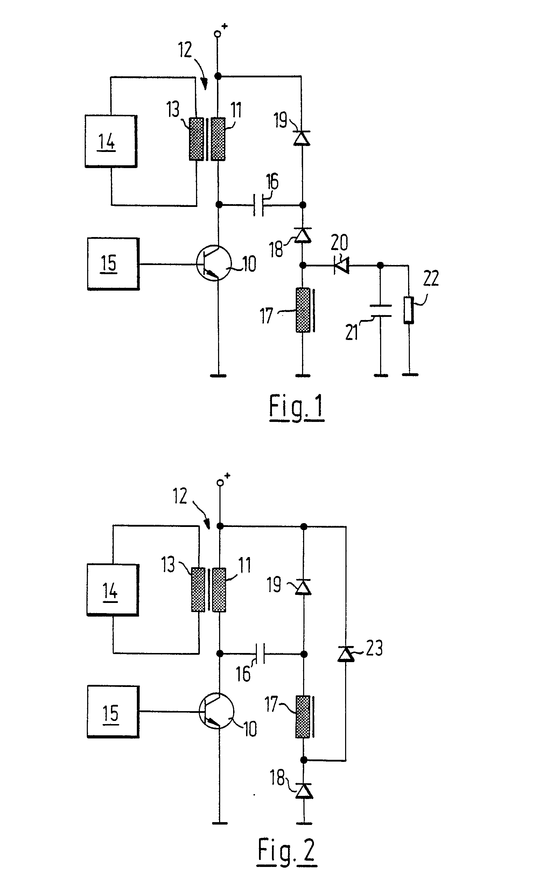

Diese Schaltungsanordnung ist mit ihren hier interessierenden Teilen in Fig. 1 dargestellt. Ein Halbleiterschalter 10 ist mit der Primärwicklung 11 eines Übertragers 12 in Reihe geschaltet, und diese Reihenschaltung ist mit einer Spannungsquelle verbunden, so daß bei leitend gesteuer tem Halbleiterschalter ein Strom vom positiven Pol der Spannungsquelle durch die Primärwicklung 11 des Übertragers 12 nach Masse fließt. Die Sekundärwicklung 13 des Übertragers 12 ist mit einer Schaltung 14 verbunden, die eine hier nicht weiter dargestellte Gleichrichterschaltung und eine zu speisende Last umfaßt. Der impulsartige Schaltbetrieb des Halbleiterschalters 10 wird durch eine Steuerschaltung 15 gesteuert, durch die der Halbleiterschalter 10 mit einer vorbestimmten Schaltfrequenz leitend gesteuert bzw. gesperrt wird.

An die Verbindung des Kollektors des Halbleiterschalters 10 mit der Primärwicklung 11 des Übertragers 12 ist ein Kondensator 16 angeschlossen, dessen zweiter Anschluß mit der Reihenschaltung einer Drosselspule 17 und einer Diode 18 verbunden ist. Außerdem ist der zweite Anschluß des Kondensators 16 über eine Diode 19 mit dem positiven Pol der Spannungsquelle verbunden. Die Reihenschaltung von Drosselspule 17 und Diode 18 ist über Masse mit dem Emitter des Halbleiterschalters 10 verbunden. Die Diode 18 ist in Durchlaßrichtung des Halbleiterschalters 10 gepolt. Die Diode 19 ist so gepolt, daß ein Entladestrom des Kondensators 16 durch die Primärwicklung 11 des Übertragers 12 in derselben Richtung wie der mit dem Halbleiterschalter 10 geschaltete Strom fließt.

An den Verbindungspunkt von Drosselspule 17 und Diode 18 ist die Kathode einer weiteren Diode 20 angeschlossen, deren Anode über ein Parallel-RC-Glied aus Kondensator 21 und Widerstand 22 mit Masse verbunden ist.

Beim Betrieb der in Fig. 1 gezeigten vorbekannten Schaltungsanordnung, in dem der Halbleiterschalter 10 mit einer Frequenz in der Größenordnung von 50 kHz durch die Steuerschaltung 15 impulsartig leitend gesteuert und gesperrt wird, erfolgt jeweils durch den Übergang des Halbleiterschalters 10 in den leitenden Zustand durch Verbinden des am Kollektor des Halbleiterschalters 10 liegenden Anschlusses des Kondensators 16 mit Masse ein Umladen des Kondensators 16, da sein nun mit Masse verbundener Anschluß zuvor, also bei gesperrtem Halbleiterschalter 10, eine positive Gleichspannung hatte, die bei Öffnung des über die Primärwicklung 11 des Übertragers 12 verlaufenden Stromkreises durch die induktive Wirkung der Primärwicklung 11 einen Wert hatte, der über dem Spannungswert der Stromquelle liegt. Bei Verbindung des Kondensators 16 über den Halbleiterschalter 10 mit Masse erfährt der Kondensator 16 einen Ladungsausgleich in dem Stromkreis über den Halbleiterschalter 10, die Drosselspule 17 und die Diode 18. Dieser Ladungsausgleich führt infolge der induktiven Wirkung der Drosselspule 17 dazu, daß der Kondensator 16 gegenüber Masse am Verbindungspunkt der beiden Dioden 18 und 19 auf die Spannung der Spannungsquelle aufgeladen wird.

Wenn dann der Halbleiterschalter 10 gesperrt wird, so ist der Stromkreis, der durch die Primärwicklung 11 des Übertragers 12, den Kondensator 16 und die Diode 19 gebildet ist, von Masse abgetrennt, wodurch der Kondensator 16 über die Diode 19 und die Primärwicklung 11 einen Ladungsausgleich erfährt und der Entladestrom über die Diode 19 in der Richtung durch die Primärwicklung 11 fließt, die mit der Richtung des mit dem Halbleiterschalter 10 geschalteten Stroms übereinstimmt. Dadurch wird erreicht, daß mit Sperren des Halbleiterschalters 10 der Stromfluß durch die Primärwicklung 11 des Übertragers 12 noch für die Entladungsdauer des Kondensators 16 fortgesetzt wird und die Bildung einer übermäßig hohen Abschaltspannung an der In duktivität der Primärwicklung 11 verhindert wird. Auf diese Wiese kann die Spannung im gesperrten Zustand des Halbleiterschalters 10 an dessen Kollektor so begrenzt werden, daß sie zwar über der Spannung der Spannungsquelle liegt, jedoch den Halbleiterschalter 10 nicht zerstört.

Die Diode 18 wird jeweils für die Dauer des über die Drosselspule 17 fließenden Ladestroms des Kondensators 16 leitend und sperrt wieder, wenn dieser Strom abgeklungen ist. Bekanntlich haben Dioden beim Übergang vom leitenden in den gesperrten Zustand eine Sperrverzögerungszeit, die bei handelsüblichen Diode der hier in Betracht kommenden Art in der Größenordnung von 250 Nanosekunden liegen kann. Diese bedeuter, daß die Diode 18 nach Abklingen des oben beschriebenen Umladevorganges des Kondensators 16 während ihrer Sperrverzögerungszeit einen Strom von dem mit ihr verbundenen Anschluß des Kondensators 16 in Sperrrichtung leiten kann, der dann durch die Drosselspule 17 nach Masse fließt. Nach dem Abklingen dieses sogenannten Inversstromes hält die Induktivität der Drosselspule 17 jedoch noch einen Stromfluß in dieser Richtung aufrecht, wodurch an dem Verbindungspunkt der Drosselspule 17 mit der Diode 18 eine relativ hohe negative Abschaltspannung entstehen kann. Diese Abschaltspannung wird bei der in Fig. 1 gezeigten Schaltungsanordnung durch eine Spannungsbegrenzungsschaltung begrenzt, die das RC-Glied 21/22 enthält und über die für die negative Abschaltspannung durchlässige Diode 20 mit der Drosselspule 17 bzw. der Diode 18 verbunden ist.

Bei der oben genannten Schaltfrequenz des Halbleiterschalters 10 in der Größenordnung von 50 kHz wird jedoch die in dem Widerstand 22 des RC-Gliedes 21/22 umgesetzte Verlustleistung so hoch, daß dadurch der Gesamtwirkungsgrad eines mit der in Fig. 1 gezeigten Schaltung arbeitenden Gerätes zu stark beeinträchtigt wird. Diese Verlustleistung könnte durch Verwendung einer Diode 18 reduziert werden, deren Sperrverzögerungszeit kürzer als zuvor erläutert ist. Wird die Schaltungsanordnung in Verbindung mit Spannungsquellen verwendet, deren Betriebsspannung in der Größenordnung von 400 Volt liegt, so müssen die verwendeten Dioden, insbesondere die Diode 18, eine Sperrspannung in der Größenordnung von 1000 Volt haben. Derartige Diode sind aber bei einer Sperrverzögerungszeit von z.B. 125 Nanosekunden sehr kostspielig.

Ein wirtschaftlicher Einsatz von Dioden mit kurzer Sperrverzögerungszeit ist nur dann möglich, wenn die erforderliche Sperrspannung reduziert werden kann. Dioden mit vergleichsweise geringer Sperrspannung haben physikalisch bedingt kurze Sperrverzögerungszeiten und sind relativ billig.

Es ist Aufgabe der Erfindung, das Problem der Überspannungsbegrenzung an der Verbindung von Drosselspule 17 und Diode 18 einer Schaltungsanordnung der in Fig. 1 gezeigen Art so zu lösen, daß Verlustleistungen vermieden werden.

Zur Lösung dieser Aufgabe ist eine Schaltungsanordnung eingangs genannter Art erfindungsgemäß derart ausgebildet, daß die Drosselspule in dem ersten Stromkreis direkt mit dem Kondensator verbunden ist und daß die Spannungsbegrenzungsschaltung eine dritte Diode ist, die mit der ersten Diode eine an die Spannungsquelle angeschaltete und entgegen deren Polarität gepolte Reihenschaltung bildet.

Eine Schaltungsanordnung dieser Art ist in Fig. 2 dargestellt. Diese Schaltungsanordnung enthält größtenteils Elemente in einer gegenseitigen Verbindung, wie sie auch in Fig. 1 beschrieben sind. Für solche Elemente sind in Fig. 2 die Bezugszeichen aus Fig. 1 verwendet. Die Arbeitsweise der in Fig. 2 gezeigten Schaltungsanordnung stimmt, soweit des Reduzieren der Verlustleistung beim Sperren des die Primärwicklung 11 des Übertragers 12 an die Spannungsquelle anschaltenden Halbleiterschalters 10 in Betracht kommt, mit der Arbeitsweise der Schaltungsanordnung nach Fig. 1 überein. Die Drosselspule 17 ist aber direkt mit dem Kondensator 16 verbunden, so daß nun die Diode 18 die Drosselspule 17 mit Masse verbindet. An den Verbindungspunkt von Drosselpule 17 und Diode 18 ist die Anode einer Diode 23 angeschlossen, deren Kathode mit dem positiven Pol der Spannungsquelle verbunden ist. Die Dioden 18 und 23 bilden somit eine Reihenschaltung, die an die Spannungsquelle angeschaltet ist und entgegen deren Polarität gepolt ist.

An dem Verbindungspunkt von Drosselspule 17 und Diode 18 würde auch bei der Schaltungsanordnung nach Fig. 2 nach dem Übergang der Diode 18 vom leitenden in den gesperrten Zustand eine hohe Überspannung infolge des oben beschriebenen Inversstromes auftreten, der während der Sperrverzögerungszeit der Diode 28 verursacht wird. Diese Überspannung ist jedoch an dem dem Kondensator 16 abgewandten Anschluß der Drosselspule 17 nun positiv, so daß sie über die Diode 23 zur Spannungsquelle hin abgeleitet wird, soweit sie höher ist als die positive Spannung der Spannungsquelle. Die Diode 23 begrenzt somit die Überspannung auf einen Wert, der der Spannung der Spannungsquelle entspricht. Somit muß die Sperrspannung der Diode 18 lediglich in der Größenordnung dieser Spannung liegen. Gleiches gilt für die Sperrspannung der Diode 23. Die Diode 23 hat außerdem die Funktion der Rückführung der beim Schaltvorgang der Diode 18 in der Drosselspule 17 gespeicherten Energie zur Spannungsquelle. Diese Energie muß also nicht als Verlustleistung in einem ohmschen Widerstand vernichtet werden, wie es bei einer Schaltungsanordnung nach Fig. 1 in der dort gezeigten Spannungsbegrenzungsschaltung mit dem Widerstand 22 der Fall ist.

Die Induktivität der Drosselspule 17 kann Eigenschwingungen verursachen. Diese können durch ein der Drosselspule 17 parallelgeschaltetes RC-Glied bedämpft werden, das in Fig. 2 nicht dargestellt ist. Eine ähnliche Wirkung hat auch ein RC-Glied, das der Diode 18 oder der Diode 23 parallelgeschaltet ist.

Die in Fig. 2 gezeigte Schaltungsanordnung stellt hinsichtlich der gewählten Polaritäten der Spannungsquelle, der Diode und des Halbleiterschalters ein Ausführungsbeispiel dar. Ebenso kann die Erfindung auch dann angewendet werden, wenn die Schaltungsanordnung invertiert ist, d.h. wenn die Spannungsquelle, der Halbleiterschalter 10 und die Diode 18, 19 und 23 gegenüber den in Fig. 2 gezeigten Verhältnissen umgekehrte Polaritäten haben.

## Ansprüche

Schaltungsanordnung zum Reduzieren der Verlustleistung beim Sperren eines eine Induktivität an eine Spannungsquelle anschaltenden Halbleiterschalters, mit einem an die Verbindung von Halbleiterschalter und Induktivität angeschalteten Kondensator, der in einem den Halbleiterschalter, eine Drosselspule und eine erste Diode enthaltenden ersten Stromkreis und in einem eine zweite Diode und die Induktivität enthaltenden zweiten Stromkreis liegt, wobei die zweite Diode so gepolt ist, daß ein Entladestrom des Kondensators in Richtung des mit dem Halbleiterschalter geschalteten Stroms durch die Induktivität fließt, und mit einer an den Verbindungspunkt von erster Diode und Drosselspule angeschlossenen Spannungsbegrenzungsschaltung, dadurch **gekennzeichnet,** daß die Drosselspule (17) in dem ersten Stromkreis direkt mit dem Kondensator (16) verbunden ist und daß die Spannungsbegrenzungsschaltung eine dritte Diode (23) ist, die mit der ersten Diode (18) eine an die Spannungsquelle angeschaltete und entgegen deren Polarität gepolte Reihenschaltung bildet.

Fig. 1

Fig. 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-4 365 171 (ARCHER)<br>* Spalte 5, Zeilen 18-22; Figur 2 *<br>----- | 1 | H 03 K 17/08 |
| | | | **RECHERCHIERTE SACHGEBIETE (Int. Cl.4)**<br><br>H 03 K |

Der vorliegende Recherchenbericht wurde für alle Patentansprüche erstellt

| Recherchenort | Abschlußdatum der Recherche | Prüfer |
|---|---|---|
| DEN HAAG | 22-06-1988 | CANTARELLI R.J.H. |

EPO FORM 1503 03.82 (P0403)